(19) Europäisches Patentamt
European Patent Office
Office européen des brevets

(11) **EP 2 830 098 A1**

(12) **EUROPEAN PATENT APPLICATION**

(43) Date of publication:
**28.01.2015 Bulletin 2015/05**

(51) Int Cl.:
***H01L 31/0224*** (2006.01)  ***F24J 2/48*** (2006.01)
***G02B 5/00*** (2006.01)

(21) Application number: **13003708.8**

(22) Date of filing: **24.07.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ETH Zurich**
**8092 Zurich (CH)**

(72) Inventors:
• **Poulikakos, Dimos**
  **8702 Zollikon (CH)**
• **Eghlidi, Mohammad Hadi**
  **8051 Zürich (CH)**
• **Tagliabue, Giulia**
  **8902 Urdorf (CH)**

(54) **Thin film broadband plasmonic absorber**

(57)   The present invention relates to a method for the production of a thin film broadband plasmonic absorber. The proposed absorber comprises a dielectric layer, on the back side of said dielectric layer a reflecting layer, and on the top side of said dielectric layer a structured layer. The method comprises at least the following steps in given order: providing a dielectric layer with a thickness in the range of 30-80 nm on the back side of which a reflecting layer is located; applying a mask of a closely and densely packed monolayer of spheres with radius $R_{bead}$ in the range of 100-250 nm on the top side of said dielectric layer, optionally followed by an etching step for the reduction of the radius of the spheres; depositing the material of the structured layer through the inter-spaces between the mask onto the dielectric layer in a physical vapour deposition process to form the structured layer with a height of the structured layer in the range of 50-150 nm; removing said mask. Furthermore the present invention relates to an absorber structure preferably made using such a process and uses of such an absorber structure in the field of solar light harvesting devices and/or security devices.

a

FIG. 1

EP 2 830 098 A1

# Description

## TECHNICAL FIELD

The present invention relates to thin film broadband plasmonic absorbers, methods for making same and uses thereof.

## PRIOR ART

During the past few years, plasmonic structures have been increasingly employed in various solar light harvesting applications, e.g. as light management structures in solar cells, nano-scale heat sources in thermal photovoltaic or thermoelectric systems and hot-electrons generators for photochemical reactions or solid-state devices. The main promise of plasmonics is the unique capability to fulfill demanding requirements of such devices which need to be broadband as well as insensitive to light polarization and angle of incidence, and for several novel applications, sub-wavelength in thickness. In addition, a facile and controllable nanofabrication technique is required on the way to realistic applications. Unlike polymer-metal nano-composites, which can fulfill some of these requirements, well-defined nanopatterns usually provide access to hot-spots where energy is strongly concentrated and subsequently exploited. Aydin et al. (Aydin, K.; Ferry, V. E.; Briggs, R. M.; Atwater, H. A. Nat Commun 2011, 2) first introduced a plasmonic broadband absorber taking advantage of multiple resonances in a metal-insulator-metal (MIM) stack with a top silver film consisting of parallel lines, parallel structured lines or crossed trapezoidal arrays and achieved 71% average absorption within the visible spectrum (400-700 nm). While different geometries showed further improvements their small scale structuring is attained with difficult to upscale fabrication methods. A different theoretical approach based on conformal transformations has exploited non-resonant nano-focusing at the end of sharp tips or grooves to achieve plasmonic nanostructures with very large absorption cross-sections over a broad spectral range, and following a similar principle, Sondergaard et al. (Sondergaard, T.; Novikov, S. M.; Holmgaard, T.; Eriksen, R. L.; Beermann, J.; Han, Z. H.; Pedersen, K.; Bozhevolnyi, S. I. Nat Commun 2012, 3) realized a broadband absorber consisting of an array of ultra-sharp convex grooves. Despite impressive results (>87% absorption over 450-850 nm) their design requires extremely narrow features, which are achieved by a cumbersome combination of electron-beam lithography and focused ion-beam milling (also practically impossible to upscale). Moreover, the structure is not subwavelength and the focusing hot-spots are deeply buried into the structure, therefore inaccessible for several light harvesting applications.

So plasmonic absorbers have recently become important for a broad spectrum of sunlight-harvesting applications exploiting either heat generation, such as in thermal photovoltaics and solar thermoelectric, or hot-electron generation, such as in photochemical and solid state devices, but so far, despite impressive progress, combining the needed high performance with fabrication simplicity and scalability remains a serious challenge.

## SUMMARY OF THE INVENTION

Here, we propose a novel solar absorber concept, wherein we demonstrate and exploit various absorption phenomena in tapered triangle arrays in a metal-insulator-metal configuration to achieve ultrabroadband (88% average absorption in the range 380-980 nm), wide-angle and polarization-insensitive absorption. Furthermore, our absorber is subwavelength in thickness (range around 200-300 nm, preferably around 260 nm) and its fabrication is based on a facile, low-cost and potentially scalable method. In addition, the geometry of our design makes it compatible for both heat and hot electron generation. So various plasmonic absorption phenomena are made use of in an array of tapered triangles within a MIM structure. While achieving a near-ideal solar absorber, we are able to fabricate the device with a potentially low-cost and easily accessible method, a must if plasmonic solar harvesting is to become a reality outside the research laboratory. According to a first aspect of the present invention the invention therefore relates to a method for the production of a thin film broadband plasmonic absorber. The proposed thin film broadband plasmonic absorber comprises a dielectric layer, on the back side of said dielectric layer a reflecting layer, and on the top side of said dielectric layer a structured layer. The proposed method comprises at least the following steps, preferably in given order:

> providing a dielectric layer with a thickness in the range of 30-80 nm on the back side of which a reflecting layer is located;
> applying a mask of a closely and densely packed monolayer of spheres with radius $R_{bead}$, preferably in the range of 100-250 nm, on the top side of said dielectric layer, optionally followed by an etching step for the reduction of the radius of the spheres;
> depositing the material of the structured layer through the inter-spaces between the mask onto the dielectric layer in a physical vapour deposition process to form the structured layer with a height of the structured layer in the range of 50-150 nm;
> removing said mask.

Before the step of depositing the material of the structured layer it is possible to apply further steps e.g. a short plasma treatment e.g. in order to make the dielectric surface hydrophilic.

According to a first preferred embodiment, dielectric layer has a thickness in the range of 30-80 nm preferably in the range of 40-70 nm.

According to yet another preferred embodiment, the dielectric layer is based on or consists of a material selected from the following group of materials: silicon dioxide, mica, organic polymeric materials, in particular halogenated organic polymeric materials, preferably at least partially fluorinated organic polymeric materials.

The structured layer, according to yet another preferred embodiment, is based on or consists of metal, or a metal alloy, preferably selected from the group of metals consisting of: chromium, gold, silver, aluminum, copper, or alloys or layered structures thereof. Preferentially the structured layer has a height in the range of 70-150 nm.

It is also possible to deposit different materials successively in individual or overlapping steps. It is for example possible to initially deposit a chromium layer with e.g. a thickness in the range of 1-5 nm, and subsequently to apply a gold layer with a thickness in the range of 70-150 nm.

According to yet another preferred embodiment, reflecting layer is based on or consists of metal, or a metal alloy, preferably selected from the group of metals consisting of: gold, silver, copper, aluminum, or alloys thereof.

Generally the reflecting layer can have a thickness in the range of 50-200 nm, most preferably in the range of 70-200 nm.

For the etching according to yet another preferred embodiment a reactive ion etching process can be used. The etching effect can be adapted by adapting the corresponding parameters such as gas flow, length, choice of gas, et cetera. Preferably the desired radius of the spheres is adjusted by adjusting the etching time, which is preferably in the range of 0-180 seconds, most preferably in the range of 20-100 seconds.

For the step of removal of the mask ultrasonication can be used.

Typically, the spheres of the mask preferably all have essentially the same radius.

Generally speaking, the spheres of the mask preferably have a radius in the range of 150-200 nm.

Preferably the spheres are polystyrene spheres.

According to a second aspect of the present invention, it relates to a thin film broadband plasmonic absorber. The proposed absorber can, but need not necessarily, be obtainable or obtained using a method according to any of the preceding claims. While it is preferred to use the above-mentioned method, it is e.g. also possible to use a method in which in a first step a structure is made using the above method, subsequently a negative template is generated, and then in mass production process this negative template is used for an industrial process to produce the absorber structures.

The absorber structures comprise a dielectric layer on the back side of which a reflecting layer is located and on the top side of which a structured layer is located, wherein the dielectric layer has a thickness in the range of 30-80 nm, wherein the structured layer has a height in the range of 50-150 nm. The structured layer is a regular two-dimensional array of regular connected or disconnected elevations wherein the cross section and/or the top-face of said elevations are concave sided triangles as e.g. generated when depositing material through a mask of closely packed spheres of radius $R_{bead}$ in the range of 100-250 nm.

As concerns the materials and the dimensions, the absorber as according to this second aspect can have the same properties as outlined above in the context of the method.

According to a preferred embodiment of the above-mentioned absorber, the difference $\Delta R$ of the radius R of the concave sides of said triangular elevations and the radius $R_{bead}$ of the spheres is larger than 0 for disconnected elevations and smaller than 0 for connected elevations.

The difference $\Delta R$ can for example be in the range of 1-10 nm, preferably in the range of 1-3 nm, most preferably around 2 nm. Indeed it has been found that if the triangles are just not connected an optimum absorption property is obtainable, and this condition is usually fulfilled for a value of around 2 nm.

The concave side walls of the elevations of the structured layer can be essentially perpendicular to the surface plane of the dielectric layer, or they can be inclined with respect to the dielectric layer under an angle of up to 120°, to form pyramid-like elevations.

In the spectral range of 380-850 nm, or in the spectral range of 380-980 nm, the absorber structure can have an absorption of always more than 80%, preferably more than 85%, and/or an average absorption of more than 80%, preferably more than 85%, most preferably of in the range of 88%.

The dielectric layer of the proposed absorber structure can be chosen such that it has a thermal expansion coefficient such that its thickness varies as a function of the temperature to an extent to lead to a colour change in the absorber structure perceivable by the naked eye, wherein preferably the thermal expansion coefficient for a temperature change of 10°C leads to a change of the thickness of the dielectric layer of 2-10%.

Last but not least the present invention relates to possible uses of such an absorber structure. Specifically, the use of an absorber as outlined above, most preferably made using a method as outlined above, is proposed as a light harvesting device, preferably as a solo light harvesting device, in particular in the context of solar cells, nano-scale heat sources in thermal photovoltaic or thermoelectric systems or hot electron generators for photochemical reactions or solid-state devices, or as security devices.

Further embodiments of the invention are laid down in the dependent claims.

BRIEF DESCRIPTION OF THE DRAWINGS

Preferred embodiments of the invention are described in the following with reference to the drawings, which are for the purpose of illustrating the present preferred embodiments of the invention and not for the purpose of limiting the same. In the drawings,

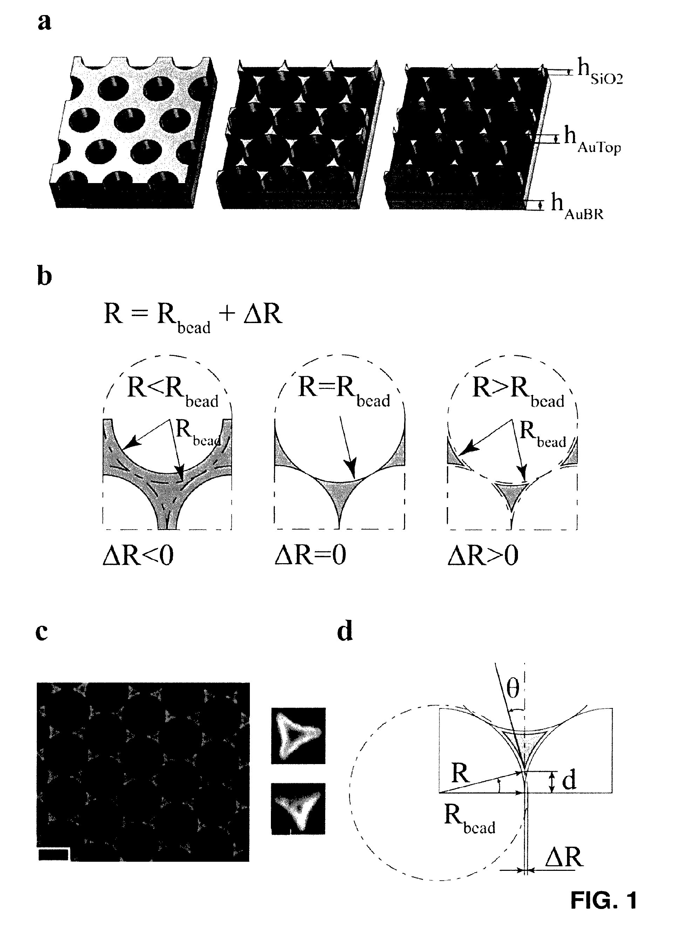

Fig. 1    shows the geometry of the proposed absorber; (a) schematic representation of the MIM absorber consisting of a gold back reflector, SiO2 dielectric spacer, and patterned gold front layer with thicknesses $h_{AuBR}$, $h_{SiO2}$, and $H_{AuFP}$, respectively; (b) definition of the in-plane geometrical parameters of the front gold pattern: $R_{bead}$ is the radius of the spherical beads used in the NSL, and R is defined as the radius of curvature of the pattern. $\Delta R$ represents the difference between R and $R_{bead}$ and can be adjusted in the fabrication; $2\theta$ and $2d$ are the tip tapering angle and the distance between two neighboring tips, respectively; (c) left: top-view scanning electron micrograph of a fabricated structure; scale bar is 200 nm; right: magnified top views of single tapered triangles; scale bars are 50 nm;

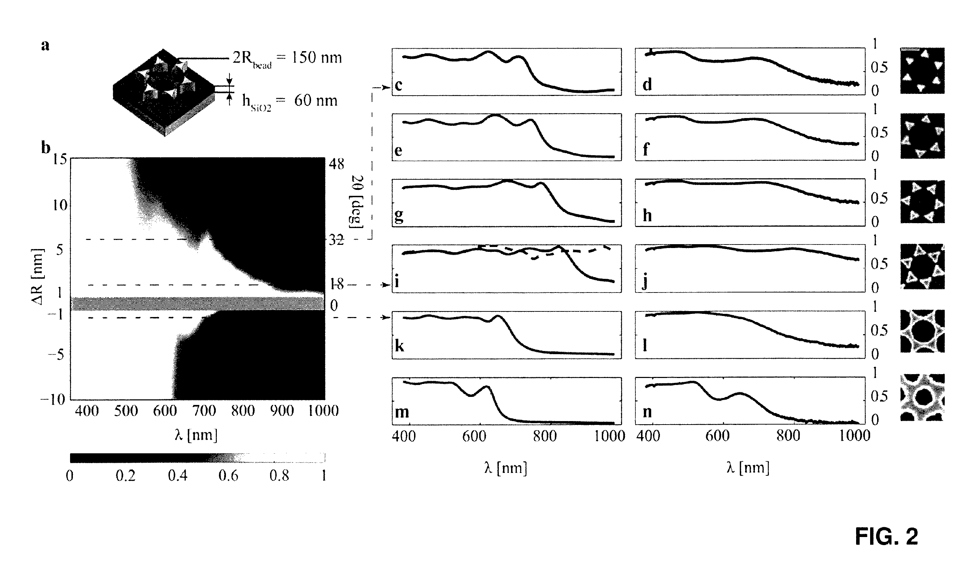

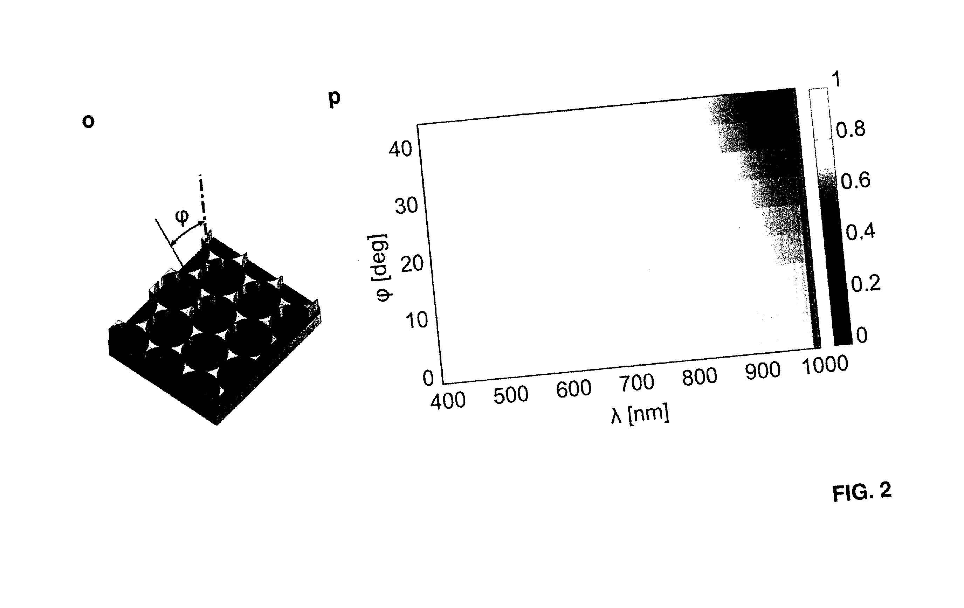

Fig. 2    shows measured and calculated absorption spectra of the absorbers; (a) schematic representation of a unit cell of the absorber; in all studied cases Rbead and $h_{SiO2}$ are kept constant while $\Delta R$ is varied; (b) simulated absorption plotted as a function of wavelength $\lambda$ and $\Delta R$; the absorption bandwidth is very large for small positive $\Delta R$'s; simulations for $\Delta R$ between 0 nm and 1 nm turned out to be challenging; (c-j) calculated (left column) and measured (right column) absorption spectra for different values of $\Delta R$; from top to bottom: $\Delta R$ = 6 nm (c,d), 4 nm (e,f), 3 nm (g,h), 2 and 1 nm (i,j); the spectral response for the case of small $\Delta R$ becomes very sensitive to slight changes in this value; therefore, the ultra-broadband absorption behaviour observed in (j) can be viewed as the result of a superposition of different cases with slightly different $\Delta R$ values, two typical values of which are calculated in (i): solid ($\Delta R$ = 2 nm) and dashed ($\Delta R$ = 1 nm) lines; the SEM pictures on the right show unit cells of the fabricated structure for each case; scale bar is 200 nm; (o): schematic drawing of the absorber with light incident at an angle $\varphi$; (p): experimentally measured absorption plotted as a function of wavelength $\lambda$ and angle of incidence $\varphi$; the objective used for excitation (NA = 0.75) allowed excitation angles up to $\varphi$ = 48°;

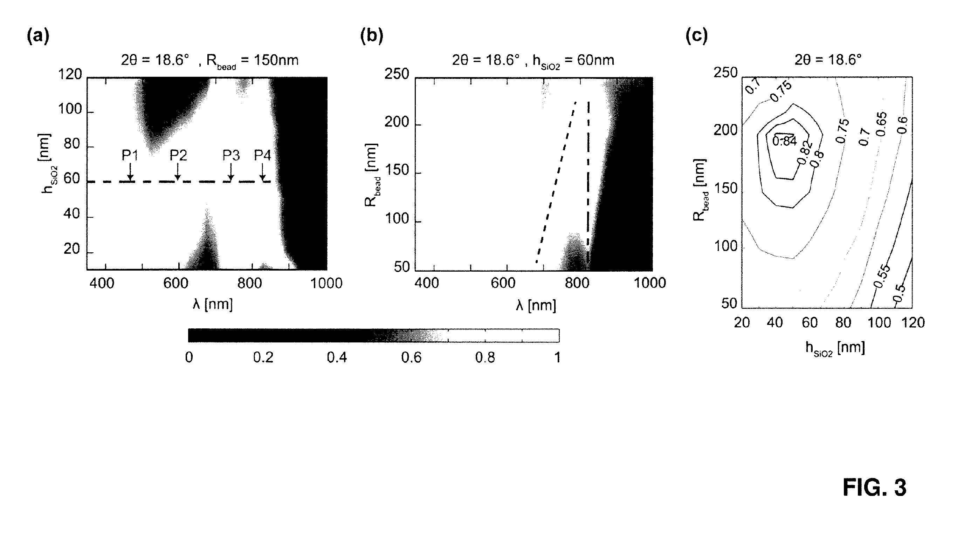

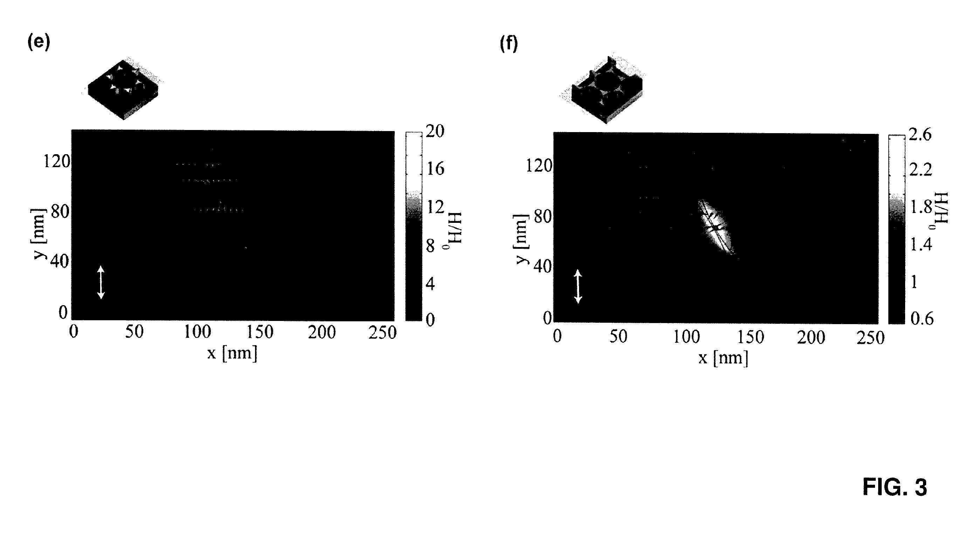

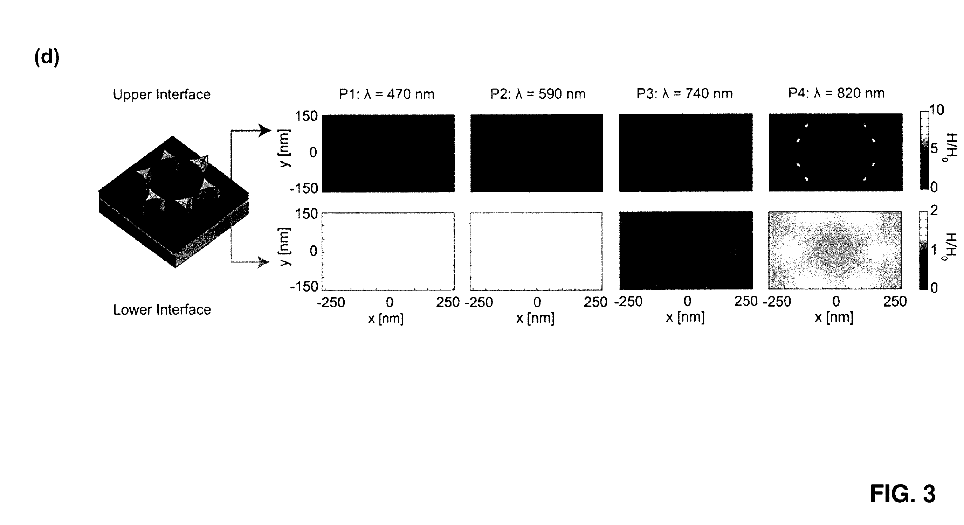

Fig. 3    shows absorption spectra vs. geometrical parameters and field profiles; (a) simulated absorption spectrum as a function of $h_{SiO2}$ for $R_{bead}$ = 150 nm, $h_{AuBR} = h_{AuFP}$ = 100 nm; the dashed line indicates the best case, which also corresponds to the experimentally realized absorber; the arrows P1-P4 indicate the position of the main absorption peaks; (b) simulated absorption spectrum as a function of $R_{bead}$ for $h_{SiO2}$ = 60 nm, $h_{AuBR} = h_{AuFP}$ = 100 nm; the eye-guiding dotted and dotted-dashed lines show the change in the absorption peaks corresponding to P3 and P4, respectively; (c) contour plot showing total absorption of sunlight, $A_{tot}$, as a function of geometrical parameters $R_{bead}$ and $h_{SiO2}$; in order to compare similar tip geometries, $\Delta R/R_{bead}$ is kept constant and equal to 0.0133 ($2\theta$ = 18.6°); absorption is calculated within the spectral range 350-1000 nm assuming the solar irradiance for the standard AM1.5 (air mass) spectrum; (d) normalized magnetic field (H) profiles at two cross-sections within the SiO2 layer for the cases specified by P1-P4 in (a) (upper cross-section: interface between the front Au pattern and the SiO2 layer; lower cross-section: interface between the SiO2 layer and the gold back reflector);

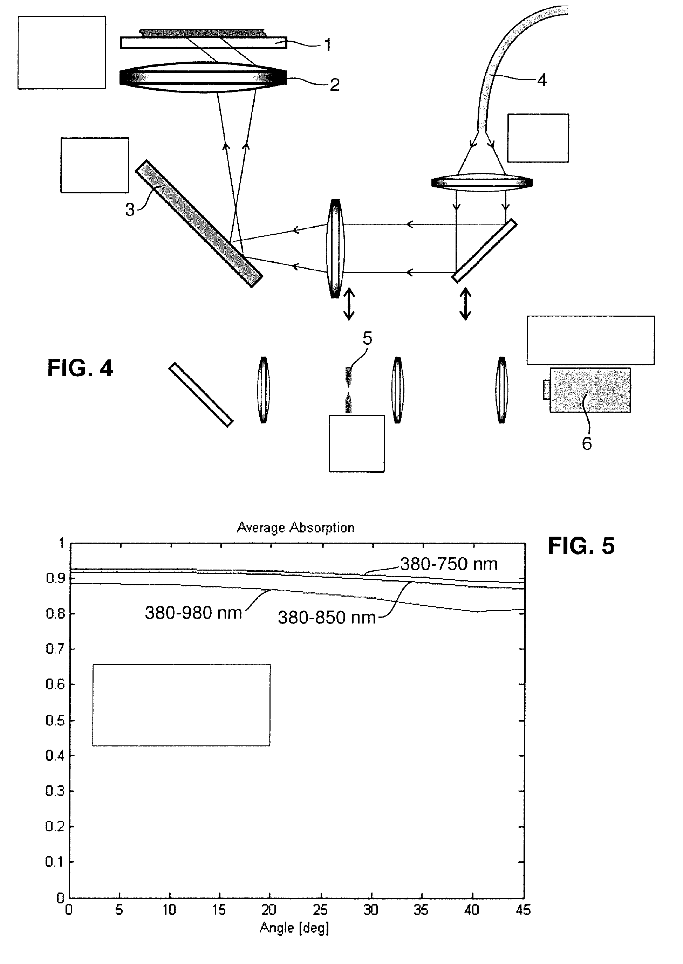

Fig. 4    shows the optical measurement setup;

Fig. 5    shows the measured average absorption, average over three different ranges versus excitation incidence angle;

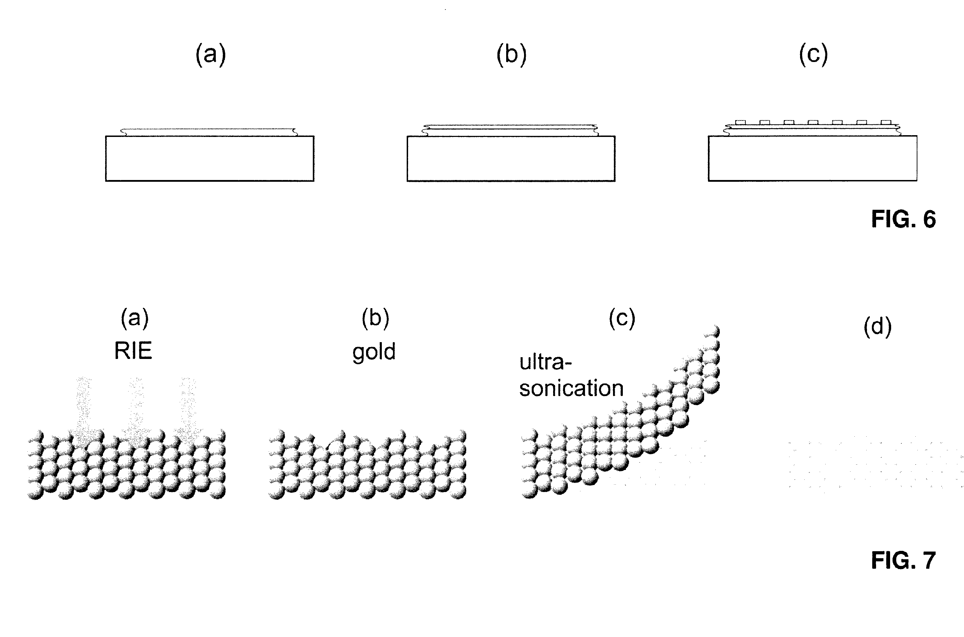

Fig. 6    shows the fabrication steps: a) evaporating 100 nm gold back reflector; (b) evaporating 60 nm SiO2 dielectric spacer; (c) creating front nano-pattern using NSL and RIE (see Fig. 7);

Fig. 7    shows the steps for fabricating the front nano-pattern; nanosphere lithography (NSL) and reactive ion etching (RIE): (a) a closely packed monolayer of polystyrene beads (Sigma Aldrich, diameter 300 nm) is created on the SiO2 spacer layer using dip-coating with controlled withdrawal velocity and solution concentration; then reactive ion etching (RIE) is used to decrease the size of the beads; (b) 100 nm gold is evaporated on the sample; deposition of gold on the glass substrate through the mask created by the beads leads to the formation of tapered triangles on the glass; (c) the beads are removed by ultrasonication in water for few seconds. (d) a gold nano-pattern is remained; and

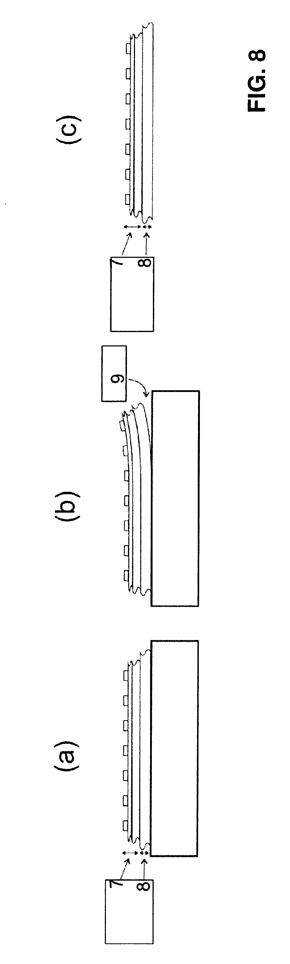

Fig. 8    shows the creation of the absorber on a thin (100 nm) membrane for temperature measurement: (a) we first use spin-coating to create a thin (100 nm) layer of PMMA on a glass substrate; then we fabricate the absorber on this layer; (b) by slowly dipping the substrate inside water we are able to detach and float the PMMA layer and absorber on water surface; (c) we then fish this thin layer and characterize it using a green laser light as illumination and an IR camera for temperature measurement.

DESCRIPTION OF PREFERRED EMBODIMENTS

A schematic representation of an absorber is given in Figure 1a,b,d where all the relevant geometrical parameters are introduced. The MIM structure comprises three layers (see Figure 1a). A 100-nm gold back-reflector and a 60-nm SiO2 layer were coated successively on a glass coverslip using electron-beam evaporation and plasma-enhanced chemical vapor deposition, respectively. A front hexagonal gold pattern was fabricated using nano-sphere lithography (NSL), in a process according to Hulteen, J. C.; Vanduyne, R. P. J Vac Sci Technol A 1995, 13, (3), 1553-1558; Tan, B. J. Y.; Sow, C. H.; Koh, T. S.; Chin, K. C.; Wee, A. T. S.; Ong, C. K. J Phys Chem B 2005, 109, (22), 11100-11109; Zhang, X. Y.; Whitney, A. V.; Zhao, J.; or Hicks, E. M.; Van Duyne, R. P. J Nanosci Nanotechno 2006, 6, (7), 1920-193420-23, which references are included in this respect, and reactive ion etching (RIE). The schematic top-view of the front pattern is shown in Figure 1b. R is defined as the radius of curvature of the pattern, and $R_{bead}$ is the radius of the spheres (beads) which are used in the NSL process and constitute a closely-packed hexagonal array. $\Delta R$ is defined as the difference between R and $R_{bead}$. For $\Delta R > 0$, the front pattern consists of an array of disconnected gold triangles with curved sides. The neighboring tapered triangles touch each other at a single point when $\Delta R = 0$ and merge together forming an array of holes for $\Delta R < 0$. Experimentally, $\Delta R$ can be adjusted between plus and minus few nanometers by relying on a combination of NSL and etching techniques (see further below). Experimentally, $\Delta R$ can be adjusted between plus and minus few nanometers by relying on overshadowing and varying the etching time of the RIE process mentioned above. By doing this, for disconnected triangles, one can vary the size of the triangles and the tapering of their tips ($2\theta$, see Figure 1d). A top view scanning electron micrograph of a created structure is shown in Figure 1c.

The performance of the proposed absorber is illustrated in Figure 2b-j where the measured and calculated absorption spectra are plotted for different values of $\Delta R$. The other geometrical parameters are fixed at $R_{bead}$ = 150 nm, $h_{SiO2}$ = 60 nm (see Figure 2a), and the thickness of the back reflector and the gold triangles are both equal to 100 nm. The overall structure is only 260 nm thick. The numerical simulations are carried out using COMSOL Multiphysics package (RF Module) and the absorption measurements were performed using a home-built inverted microscope. Collimated white light was used for excitation and the absorption spectrum, where

$\mathbb{A}$ was calculated as $\mathbb{A} = (\mathbb{I} - \mathbb{R})/\mathbb{I}$, where $\mathbb{I}$

and $\mathbb{R}$ are the incident (excitation) and reflected spectra, respectively. The light transmitted through the absorber was negligible.

Both simulation and experimental data suggest that decreasing $\Delta R$ (equivalently decreasing $2\theta$) increases the absorption bandwidth while maintaining a reasonably large absorption within the bandwidth. The best experimental result in terms of broadness is obtained at $\Delta R \approx 2$ nm (see Figure 2j), for which the neighboring tapered triangles tips are at the closest distance but still separated. Here, absorption stays above 85% within the spectral range 380-850 nm and slowly drops to 70% at 980 nm. We reach an average absorption slightly larger than 88% within the spectral range 380-980 nm. The numerical results in Figure 2b show a rapid increase in the absorption bandwidth as $\Delta R$ approaches zero (equivalently, the distance between the tips of neighboring triangles as well as 0 decrease). As mentioned above, $\Delta R$ can be controlled with nanometer resolution by using a slow enough etching process. While the fabrication relies on a facile method, the results show the potential of the proposed concept to easily adjust the absorption bandwidth and achieve a near-ideal absorber.

Angular insensitivity is one of the important properties of an ideal absorber. To assess the angular sensitivity of our absorber we illuminated it with plane waves at different angles of incidence. We obtained this by focusing the excitation light at different positions on the back-focal plane of the objective with which we were able to reach angles up to 48 degrees (numerical aperture, NA = 0.75). The measured absorption spectra for the best experimental case (Figure 2j) for incidence angles from 0 to 45 degrees are summarized in Figure 2k. The results show that a broad absorption spectrum is preserved even at large angles of incidence. Finally, our design concept is inherently polarization insensitive at normal incidence. This is due to the geometrical planar symmetries that it contains. In addition, the measurements, which are performed with unpolarized light and the simulations (not shown for brevity) confirm a similar insensitivity for angles away from the normal.

The broadband absorption behavior of the proposed design is the collective result of a number of plasmonic absorption events. These events occur at different locations of the spectrum and, after proper choice of the geometrical dimensions, piece together a continuous absorption band. To assess the impact of the dielectric spacer thickness, in Figure 3a we show the calculated absorption spectra for different values of $h_{SiO2}$. All of the other geometrical parameters are kept constant ($R_{bead}$ = 150 nm, $h_{Au,FP}$ = 100 nm, $\Delta R$ = 2 nm, see Figure 2a). The horizontal dashed line shows the situation that we have in the experiment, $h_{SiO2}$ = 60 nm (Figure 2j), which leads to very high absorption over the entire absorption spectrum. Moving away from this optimal thickness leads to the appearance of spectral bands with high reflection in the visible range. To understand the origin of the broadband absorption, we studied the field distributions inside the dielectric layer on two horizontal cross-sections, close to the top pattern and close to the back reflector. Figure 3d shows magnetic field enhancement profiles at four absorption peaks indicated by P1 - P4 in Figure 3 a.

At P1 ($\lambda$ = 470 nm) we note that the electromagnetic energy is concentrated close to the back-reflector. This indicates that the absorption at this wavelength originates from the grating-mediated coupling of electromagnetic field into the surface plasmon polariton (SPP) excited at the interface between SiO2 layer and gold back reflector. Our analytical calculations for the simplified three-layer (air-SiO2-gold) structure predicts the grating coupled SPP (corresponding to the grating period = 2Rbead = 300 nm) at $\lambda$ = 498 nm, which is close to the observed resonance. This absorption resonance only slightly blue-shifts as the value of $h_{SiO2}$ increases. The absorption peak at P2 ($\lambda$ = 590 nm) is substantially influenced by $h_{SiO2}$ and becomes weaker for SiO2 thicknesses away from 60 nm. This peak red-shifts as $h_{SiO2}$ increases and is a result of a dipole-dipole interaction between the triangles and the gold back reflector. The field profiles in Figure 3d (P2) verify the contribution of both triangles and back reflector for this resonance. The absorption event at P3 is mainly originating from the localized surface plasmon (LSP) resonance of the individual tapered triangles. Our simulations of an isolated tapered triangle on a glass substrate reveal a dominant absorption peak for $\lambda$ close to 720 nm which complies with the observed resonance at P3. The position of this absorption peak is only slightly influenced by $h_{SiO2}$ and the weak field enhancement on the back reflector confirms the dominant contribution of the individual triangles in the resonance (see Figure 3d (P3)). Absorption at P4 originates from the presence of the tips where energy is accumulated and dissipated. This is evident from the strong field enhancement at the tips shown in Figure 3d (P4).

Further evidence for the above-mentioned attributes is given in Figure 3b where calculated absorption spectra are plotted as function of $R_{bead}$. Here, by maintaining the ratio $\Delta R/R_{bead}$ constant, we are able to keep the tip angle, 2$\theta$, constant and equal to 18.6°. Other geometrical values are $h_{SiO2}$ = 60 nm, and $h_{Au,FP}$ = 100 nm. The two eye-guiding lines show the variation of the position of the resonances corresponding to P3 and P4 (see Figure 3a). The resonance corresponding to P3 (dotted line) red-shifts as $R_{bead}$ increases. This is in agreement with the expected red-shift of the LSP resonance of the triangles as their size (or equivalently $R_{bead}$) increases. On the other hand, the invariance of 2$\theta$ ensures a practically unchanged spectral position of the absorption peak corresponding to P4 (dashed-dotted line), although $R_{bead}$ and 2d (see Figure 1b) vary over a large range. The focusing of the electromagnetic energy at the end of tapered tips is sensitive only to the tip opening angle. The spectral position of this absorption peak determines the upper cut-off of the absorption band and as seen in Figure 2b can be greatly increased by decreasing the tip angle, 2$\theta$. Another intriguing trend can be observed in Fig. 2b: while the absorption spectrum broadens dramatically for positive $\Delta R$'s close to zero, its bandwidth abruptly drops as soon as the tips of the gold tapered triangles merge ($\Delta R$ < 0). More than 250 nm drop in bandwidth at longer wavelengths occurs as $\Delta R$ is varied from 1 nm to -1 nm.

In Fig. 3e and f we show the magnetic field profiles (color-coded) and in-plane energy flow (Poynting) vectors for two cases of disconnected ($\Delta R$ = 1 nm) and connected ($\Delta R$ = -1 nm) triangles at wavelength 950 nm, respectively. The profiles are plotted in the cross-sections where the largest concentration and absorption of the electromagnetic energy occur. For disconnected triangles (Fig. 3e), absorption originates from a combination of the plasmonic resonance of the triangles and a non-resonance phenomenon due to the propagation of the electromagnetic energy toward the end of the tapered tips, where the group velocity vanishes and energy accumulates. For the situation considered here ($R_{bead}$ = 150 nm) the latter effect dominates for wavelengths close to the upper cut-off This is evident from the distribution of the power flow vectors which strongly converge at the end of the tips where the power dissipation takes place. As soon as the tapered tips touch each other ($\Delta R$ < 0), the accumulated electromagnetic energy channels to the next triangle and due to reciprocity couples out to free space without being absorbed in the metal (Fig. 3f and supplementary information, movie). In this case, although the Poynting vectors converge at the narrowest part between two triangles the total absorption remains much smaller than that of disconnected triangles. This leads to the observed drop in absorption at longer wavelengths. For large negative $\Delta R$'s, both resonant and non-resonant dissipation phenomena vanish and the absorption spectrum resembles that of a flat gold layer. It is important to note that the above discussion refers to our arrangement, where the tapered triangles can be connected only via their tips, so that the optimal situation of broad absorption is achieved when the triangles are just disconnected. However, in a different design where the tips of triangles touch the sides of the neighboring ones it is shown that an array of connected triangles could still lead to a fairly broad absorption.

In order to assess the performance of our concept in absorbing the solar spectrum, we calculate the total absorption as

$$A_{tot} = \frac{\int_{350nm}^{1000nm} A(\lambda)I(\lambda)d\lambda}{\int_{350nm}^{1000nm} I(\lambda)d\lambda}$$

where A($\lambda$) and I($\lambda$) are the absorption of the structure and the solar irradiance for the standard AM1.5 (air mass) spectrum, respectively. In calculating the above absorption we consider the spectral range of 350-1000 nm, for which we performed measurements and simulations. The discarded part contains around 25% of the total solar energy. The contour plot in Figure 3c shows the simulated total absorption as a function of thickness of the SiO2 layer, $h_{SiO2}$, and the size of the beads used for NSL, $R_{bead}$. In these simulations we used a constant value for $\Delta R/R_{bead}$ (= 0.0133, corresponding to $\Delta R$ = 2 nm at $R_{bead}$ = 150 nm), to ensure a constant angle at the tips of the triangles, 20. Based on the above-mentioned studies, this assumption ensures almost the same upper cut-off wavelength of the absorption band for all the cases. The optimal geometry with $R_{bead}$ = 200 nm and $h_{SiO2}$ = 45 nm leads to a total absorption of 84%. As explained before (see Figure 2b), smaller values for ΔR can lead to substantially broader absorption spectrum and therefore increase the total absorption. Furthermore, Figure 3c shows that the total absorption around the optimum is quite insensitive to $h_{SiO2}$ and $R_{bead}$, making the performance of such a device highly tolerant to fabrication imperfections.

Materials and methods

Optical measurement: Absorption measurements are performed using a home-built inverted microscope equipped with an air objective (numerical aperture 0.75) for exciting the sample and collecting the reflected and scattered light and a spectrometer (Princeton Instruments). White light is generated by a Xenon lamp and is brought to the set-up with an optical fiber (105 $\mu$m core size) in order to improve its spatial coherence. Plane wave excitations with different angles of incidence are achieved by focusing the light beam at different positions on the back focal plane of the objective (Fig. 4). The relation $\mathbb{A} = (\mathbb{I} - \mathbb{R})/\mathbb{I}$ was used to calculate the absorption spectrum, where where $\mathbb{A}$, $\mathbb{I}$ and $\mathbb{R}$ are the absorption, incident (excitation) and reflected spectra, respectively. The light transmitted through the absorber was negligible. $\mathbb{I}$ was measured using the reflected spectrum from a broadband silver mirror. This ensures accounting for excitation spectral non-uniformities and losses along the detection path. Furthermore, dark counts of the spectrometer and background spectra were subtracted from all the measured spectra.

The measured values are as follows: minimum and mean value of absorption for different wavelength ranges:

Absorption stays above:

a) 86% in the range 380-750nm
b) 85% in the range 380-850nm
c) 67% in the range 380-980nm

Average absorption is:

a) 93% in the range 380-750nm
b) 92% in the range 380-850nm
c) 88% in the range 380-980nm

Fig. 5 shows the effect of light incidence angle on the average absorption for different wavelength ranges (experimental data); the ranges in the inset show the wavelength range within which the average absorption is calculated.

a) Average absorption for 380-750nm: max(0deg) =93% min(45deg)=89% Delta= 4%
b) Average absorption for 380-850nm: max(0deg) = 92% min(45deg)=87% Delta= 5%
c) Average absorption for 380-980nm: max(0deg) =89% min(40deg)=81% Delta= 8%

Fabrication: Glass coverslips were coated first with a 100-nm gold back reflector (electron beam evaporation) and successively by a 60-nm SiO2 layer (plasma enhanced chemical vapor deposition). The thickness of the dielectric spacer and optical properties of SiO2 and gold layers were always measured using ellipsometry. After cleaning with a 6:1:1 solution of H2O:NH40H:H2O2 in ultrasonic bath for 10min, the samples were stored for 24h in ethanol to ensure full hydrophilicity of the glass surface The hexagonal gold patterns are fabricated using nanosphere lithography (NSL) and etching techniques as follows: a closely packed monolayer of polystyrene beads (Sigma Aldrich, diameter 300 nm) is created using dip-coating with controlled withdrawal velocity and solution concentration.. Reactive ion etching is then used to reduce the bead size (100sccm Ar, 10sccm 02, 50W, 100$\mu$bar). The bead size is controlled by adjusting the etching time. Due to overshadowing in the NSL, zero or short etching times result in disconnected curved triangles (ΔR > 0). The fmal pattern is created by evaporating 100 nm of gold (after 2 nm Cr adhesion layer) through the bead mask and by successively removing the beads by ultrasonication. The fabrication is illustrated in figures 6 and 7.

Detailed parameters in fabrication and characterization:

Back Reflector:

Physical Vapor Deposition (Device used: PlassysMEB550SL) of

a) 10nm Cr (0. 5nm/s) - adhesion layer
b) 100nm Au (0.25nm/s) - back reflector

Dielectric layer:

a) SiO2: Plasma Enhanced Chemical Vapor Deposition (Oxford Instruments PECVD 80+) of 20nm to 120nm of Si02
b) TiO2: Physical Vapor Deposition with Univex500 of 20nm to 70nm TiO2 (10kV, 55mA, 0.1nm/s)

Other possibilities are:

A1203 : Physical Vapor Deposition (Univex500)
Si: Physical Vapor Deposition (Univex500)

**Front Pattern:**

Do a short plasma treatment (02, 0.7mbar, 150W, 1min) to make the dielectric surface hydrophilic.

Creation of the monolayer of polystyrene beads (Diameter= 200nm-500nm). See further below for details and alternatives of this process.

Etching of the polystyrene beads for controlling the pattern characteristics (connected vs disconnected structures, degree of tapering). Use of Reactive Ion Etching process (RIE 76 , Oxford Instruments Plasmalab 80) : pressure = 0.260 microBar, gases = 02 (100sccm), CF4(4.2sccm), power = 100W, RF 13.56MHz . The etching time has to be controlled within 0s to 180s.

Physical Vapor Deposition (Plassys MEB550SL) of

  a) 2nm Cr (0.5nm/s)
  b) 100nm Au (0.25nm/s)

Removal of the polystyrene beads via sonication (1-5min, full power).

**Ellipsometry:**

The optical properties of the fabricated Au (Oszi model) and dielectric ($SiO_2$ - Sellmeier model, $TiO_2$ - Tauc-Lorentz formula) can be measured with an ellipsometer.

**Fabrication of the Self Assembled monolayer:**

A commercial solution of monodispersed polystyrene beads (Diameter=200nm-500nm) with initial concentration of 10% wt was used.

**Different alternative methods:**

Spin coating: solution 5-10%wt, V=approx 10$\mu$L (for 10x10mm sample), 6000rpm, 1min Well with concave meniscus: well size (o-ring): D=10mm, Solution: 5-10%wt (dilution with 90%De-Ionized Water, 10% Ethanol), Volume= approx 25$\mu$L. Eventually use of surfactant in the dilution water (Sodium Dodecyl Sulfate SDS)

Dip-coating: Solution: 1-10%wt, Humidity: approx50%, Temperature: approx 22°C, extraction Speed: 1-10$\mu$m/s

Air-water interface assembly: Solution: 1-10%wt, (Dilution with 60% De-Ionized Water, 40% Iso Propanol), The volume to be added at the interface depends on the surface area, Addition of a few droplets of SDS at the interface, Extraction Speed: 10-100$\mu$m/s. Langmuir Blodgett trough.

**Temperature measurement and applications:**

Fast temperature response of ultra-thin layers: Steady-state temperature and rise time (the time that it takes to go from ambient to a steady-state high temperature upon illuminating the absorber with light) of the absorbers were measured when illuminated with light. The results show great improvements, especially in terms of shortening the rise time (increasing speed). The already performed measurements show almost one order of magnitude shorter rise-time and around two times higher temperatures in our thin absorbers as compared to thick absorbers. We also achieved almost two orders of magnitude rise-time shortening if the absorbers are fabricated on a thin (ca 100 nm thick) membrane as compared to the case where absorbers are fabricated on a 170$\mu$m-thick glass substrate. Fig. 8 explains how to fabricate and suspend the absorber on a thin membrane. To do that we first use spin-coating to create a thin (100 nm) layer of PMMA on a glass substrate. Then we fabricate the absorber on this layer. By slowly dipping the substrate inside water we are able to detach and float the PMMA layer and absorber on water surface. We then fish this thin layer and characterize it using a green laser light as illumination and an IR camera for temperature measurement.

**Optical sensors with faster response:**

The very large rise-time shortening that we achieve in our ultra-thin absorber can help to greatly increase the speed of commercially available optical sensors which work based on thermoelectric generators. Based on the temperature measurements (explained above) one is able to improve the speed of the devices.

**Simulations:**

Primary estimation of optimal dimensions was achieved by performing a large series of full-wave simulations with Lumerical, a commercially available finite-difference time-domain (FDTD) software package, which is very efficient for broadband simulations. However, due to the staircasing errors of FDTD at sharp edges, the final simulations (which include all the results shown in this manuscript) were performed using COMSOL Multiphysics package (RF module), which is based on the fmite element method (FEM). By using symmetry and periodic (for normal excitation) or Floquet (for oblique excitation) boundary conditions the computational domain was reduced to one-fourth of a unit-cell. To model gold in the simulations, we used the optical properties tabulated in Palik's Handbook 35 which agree well with our ellipsometry measurements (see Methods, Fabrication).

In conclusion, exploiting a combination of different plasmonic absorption phenomena in an array of tapered triangles integrated in an MIM configuration, we introduced a novel ultra-broadband plasmonic absorber with average absorption 88% within the spectral range 380-980 nm. In addition, this absorber is insensitive to both light polarization and angle of incidence. While arrays of tapered triangles have been broadly studied by others, our results cannot be achieved by sole arrays of triangles. The novelty of the design relies on exploiting four different absorption phenomena (each of different nature) two of which are accessible only through the MIM configuration. Properly selecting a host of geometrical dimensions, we managed to harvest the collective benefit of these absorption events and pieced together a continuous absorption band. Our simulations show that one could go even beyond these high values, in terms of broadness and total absorption, by fine-tuning of the geometrical parameters, specifically the tip regions of the tapered triangles in the pattern. Importantly, in contrast to previous successful designs, the fabrication of our concept is based on NSL which is a low-cost and easily accessible method. Although monocrystallinity is not a stringent requirement in our design, achieving large defect-free crystals with NSL remains a challenge. This bottleneck has been addressed in recent studies 30, 31 and significant improvements are foreseen. To this end, and based on the nano-scale thickness (260 nm) of our design, we envision the up-scaling of the absorber on flexible substrates even in a roll-to-roll manner. Being ultra-thin, the absorber can efficiently elevate the temperature within a nano-scale layer, which can be exploited in various applications such as micro-fluidics, solar thermoelectrics and high temperature chemical reactions. 34 In addition, efficiently absorbing the extremely broad solar light and concentrating it at the very end of the tips, renders the present concept an interesting candidate for enhancing solar-based photochemistry and improving the efficiency of solid-state devices.

## LIST OF REFERENCE SIGNS

| 1 | absorber | 6 | spectrometer or CCD |
|---|---|---|---|
| 2 | objective | 7 | absorber |
| 3 | beam splitter | 8 | PMMA |
| 4 | white light | 9 | water |
| 5 | pinhole | | |

**Claims**

1. Method for the production of a thin film broadband plasmonic absorber comprising:

a dielectric layer,
on the back side of said dielectric layer a reflecting layer,
on the top side of said dielectric layer a structured layer,
comprising at least the following steps in given order:

providing a dielectric layer with a thickness in the range of 30-80 nm on the back side of which a reflecting layer is located;
applying a mask of a closely and densely packed monolayer of spheres with radius $R_{bead}$ in the range of 100-250 nm on the top side of said dielectric layer, optionally followed by an etching step for the reduction of the radius of the spheres;
depositing the material of the structured layer through the inter-spaces between the mask onto the dielectric layer in a physical vapour deposition process to form the structured layer with a height of the structured layer in the range of 50-150 nm;
removing said mask.

2. Method according to claim 1, wherein the dielectric layer has a thickness in the range of 30-80 nm preferably in the range of 40-70 nm.

3. Method according to any of the preceding claims, wherein the dielectric layer is based on or consists of a material selected from the following group of materials: silicon dioxide, mica, organic polymeric materials, in particular halogenated organic polymeric materials, preferably at least partially fluorinated organic polymeric materials.

4. Method according to any of the preceding claims, wherein the structured layer is based on or consists of metal, or a metal alloy, preferably selected from the group of metals consisting of: chromium, gold, silver, copper, or alloys or layered structures thereof, wherein preferably the structured layer has a height in the range of 70-150 nm, and/or wherein different materials are preferably successively deposited in individual steps, wherein most preferably initially a chromium layer is applied with a thickness in the range of 1-5 nm, and subsequently a gold layer is applied with a thickness in the range of 70-140 nm.

5. Method according to any of the preceding claims, wherein the reflecting layer is based on or consists of metal, or a metal alloy, preferably selected from the group of metals consisting of gold, silver, copper, aluminium, or alloys thereof, wherein preferably the reflecting layer has a thickness in the range of 70-200 nm, most preferably in the range of 90-200 nm.

6.  Method according to any of the preceding claims, wherein for the etching a reactive ion etching process is used, and wherein preferentially the desired radius of the spheres is adjusted by adjusting the etching time, which is preferably in the range of 0-180 seconds, most preferably in the range of 20-100 seconds.

7.  Method according to any of the preceding claims, wherein for the step of removal of the mask ultrasonication is used.

8.  Method according to any of the preceding claims, wherein the spheres of the mask preferably all have essentially the same radius, wherein they preferably have a radius in the range of 150-200 nm, and wherein further preferably the spheres are polystyrene spheres.

9.  Thin film broadband plasmonic absorber, preferably obtainable or obtained using a method according to any of the preceding claims, comprising a dielectric layer on the back side of which a reflecting layer is located and on the top side of which a structured layer is located,
    wherein the dielectric layer has a thickness in the range of 30-80 nm,
    wherein the structured layer has a height in the range of 50-150 nm,
    wherein the structured layer is a regular two-dimensional array of regular connected or disconnected elevations wherein the cross section and/or the top-face of said elevations are concave sided triangles as generated when depositing material through a mask of closely packed spheres of radius $R_{bead}$ in the range of 100-250 nm.

10. Absorber according to claim 9, the difference $\Delta R$ of the radius R of the concave sides of said triangular elevations and the radius $R_{bead}$ of the spheres is larger than 0 for disconnected elevations and smaller than 0 for connected elevations.

11. Absorber according to claim 10, wherein the difference $\Delta R$ is in the range of 1-10 nm, preferably in the range of 1-3 nm, most preferably around 2 nm.

12. Absorber according to any of claims 9-11, wherein the concave side walls of the elevations of the structured layer are essentially perpendicular to the surface plane of the dielectric layer, or are inclined with respect to the dielectric layer under an angle of up to 120°, to form pyramid-like elevations.

13. Absorber according to any of the preceding claims 9-12, wherein in the spectral range of 380-850 nm, or in the spectral range of 380-980 nm, it has an absorption of always more than 80%, preferably more than 85%, and/or an average absorption of more than 80%, preferably more than 85%, most preferably of in the range of 88%.

14. Absorber according to any of the preceding claims 9-12, wherein the dielectric layer has a thermal expansion coefficient such that its thickness varies as a function of the temperature to an extent to lead to a colour change in the absorber structure perceivable by the naked eye, wherein preferably the thermal expansion coefficient for a temperature change of 10°C leads to a change of the thickness of the dielectric layer of 2-10%.

15. Use of an absorber according to any of the preceding claims 9-13, most preferably made using a method according to any of claims 1-8, as a light harvesting device, preferably as a solo light harvesting device, in particular in the context of solar cells, nano-scale heat sources in thermal photovoltaic or thermoelectric systems or hot electron generators for photochemical reactions or solid-state devices, or as security devices.

a

$$h_{SiO2}$$

$$h_{AuTop}$$

$$h_{AuBR}$$

b

$$R = R_{bead} + \Delta R$$

$$R < R_{bead}$$
$$R_{bead}$$
$$\Delta R < 0$$

$$R = R_{bead}$$
$$\Delta R = 0$$

$$R > R_{bead}$$
$$R_{bead}$$
$$\Delta R > 0$$

c

d

$$\theta$$
$$R$$
$$d$$
$$R_{bead}$$
$$\Delta R$$

FIG. 1

FIG. 2

FIG. 2

p

o

φ

λ [nm]

φ [deg]

FIG. 3

FIG. 3

**(d)**

Upper Interface

Lower Interface

P1: λ = 470 nm  P2: λ = 590 nm  P3: λ = 740 nm  P4: λ = 820 nm

**FIG. 3**

EP 2 830 098 A1

**FIG. 4**

**FIG. 5**

Average Absorption

380-750 nm

380-980 nm    380-850 nm

Angle [deg]

(a)                    (b)                    (c)

FIG. 6

EP 2 830 098 A1

(a)          (b)          (c)                    (d)
RIE          gold         ultra-
                          sonication

FIG. 7

EP 2 830 098 A1

(a)　　　　　　　　(b)　　　　　　　　(c)

**FIG. 8**

Europäisches
Patentamt

European
Patent Office

Office européen
des brevets

# EUROPEAN SEARCH REPORT

Application Number

EP 13 00 3708

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | KAMIL BORATAY ALICI ET AL: "Optically thin composite resonant absorber at the near-infrared band: a polarization independent and spectrally broadband configuration", OPTICS EXPRESS, vol. 19, no. 15, 18 July 2011 (2011-07-18), page 14260, XP055102880, ISSN: 1094-4087, DOI: 10.1364/OE.19.014260 * the whole document * | 1-15 | INV. H01L31/0224 F24J2/48 G02B5/00 |
| Y | US 2010/218815 A1 (GUHA SUPRATIK [US] ET AL) 2 September 2010 (2010-09-02) * paragraphs [0033] - [0035]; figures 5-8 * | 1-15 | |
| A,D | HULTEEN J C ET AL: "NANOSPHERE LOTHOGRAPHY: A MATERIALS GENERAL FABRICATION PROCESS FOR PERIODIC PARTICLE ARRAY SURFACES", JOURNAL OF VACUUM SCIENCE AND TECHNOLOGY: PART A, AVS /AIP, MELVILLE, NY., US, vol. 13, no. 3, PART 02, 1 May 1995 (1995-05-01), pages 1553-1558, XP000536492, ISSN: 0734-2101, DOI: 10.1116/1.579726 * the whole document * | 1-15 | TECHNICAL FIELDS SEARCHED (IPC) H01L F24J G02B |
| A | B. J. Y. TAN ET AL: "Fabrication of Size-Tunable Gold Nanoparticles Array with Nanosphere Lithography, Reactive Ion Etching, and Thermal Annealing", THE JOURNAL OF PHYSICAL CHEMISTRY B, vol. 109, no. 22, 1 June 2005 (2005-06-01), pages 11100-11109, XP055009379, ISSN: 1520-6106, DOI: 10.1021/jp045172n * the whole document * | 1,9 | |

-/--

The present search report has been drawn up for all claims

| Place of search | Date of completion of the search | Examiner |
|---|---|---|
| Berlin | 19 February 2014 | Rodríguez-Gironés, M |

EPO FORM 1503 03.82 (P04C01)

Europäisches
Patentamt

European
Patent Office

Office européen
des brevets

**EUROPEAN SEARCH REPORT**

Application Number

EP 13 00 3708

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | MEHDI KESHAVARZ HEDAYATI ET AL: "Tunable broadband plasmonic perfect absorber at visible frequency", APPLIED PHYSICS A; MATERIALS SCIENCE & PROCESSING, SPRINGER, BERLIN, DE, vol. 109, no. 4, 1 November 2012 (2012-11-01), pages 769-773, XP035142793, ISSN: 1432-0630, DOI: 10.1007/S00339-012-7344-1 * the whole document * | 1,9 | |

TECHNICAL FIELDS
SEARCHED       (IPC)

The present search report has been drawn up for all claims

| Place of search | Date of completion of the search | Examiner |
|---|---|---|
| Berlin | 19 February 2014 | Rodríguez-Gironés, M |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**                    EP 13 00 3708

This annex lists the patent family members relating to the patent documents cited in the above-mentioned European search report.
The members are as contained in the European Patent Office EDP file on
The European Patent Office is in no way liable for these particulars which are merely given for the purpose of information.

19-02-2014

| Patent document cited in search report | Publication date | Patent family member(s) | Publication date |
|---|---|---|---|
| US 2010218815 A1 | 02-09-2010 | CN 102612754 A<br>TW 201135949 A<br>US 2010218815 A1<br>US 2011284073 A1<br>WO 2011061011 A2 | 25-07-2012<br>16-10-2011<br>02-09-2010<br>24-11-2011<br>26-05-2011 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **AYDIN, K. ; FERRY, V. E. ; BRIGGS, R. M. ; ATWA-TER, H. A.** *Nat Commun,* 2011, 2
- **SONDERGAARD, T. ; NOVIKOV, S. M.; ; HOLM-GAARD, T. ; ERIKSEN, R. L. ; BEERMANN, J.; ; HAN, Z. H.; ; PEDERSEN, K. ; BOZHEVOLNYI, S. I.** *Nat Commun,* 2012, 3
- **HULTEEN, J. C. ; VANDUYNE, R. P.** *J Vac Sci Technol A,* 1995, vol. 13 (3), 1553-1558
- **TAN, B. J. Y. ; SOW, C. H. ; KOH, T. S. ; CHIN, K. C. ; WEE, A. T. S. ; ONG, C. K.** *J Phys Chem B,* vol. 109 (22), 11100-11109
- **ZHANG, X. Y.; ; WHITNEY, A. V.; ; ZHAO, J. ; HICKS, E. M.; ; VAN DUYNE, R. P.** *J Nanosci Nanotechno,* 2006, vol. 6 (7), 1920-193420, 23